# EUROPEAN PATENT APPLICATION

(11) **EP 2 482 309 A1**
(43) Date of publication of application: **01.08.2012**
(21) Application number: 11152905.3
(22) Date of filing: 01.02.2011
(51) Int. Cl.: H01L 21/673, H01L 21/02

(54) **Arrangement for processing optoelectronic devices**

(71) Applicant: OSRAM Opto Semiconductors GmbH, 93055 Regensburg (DE)
(72) Inventor: Ng, Aylwin, 11900, Penang (MY); Bernard Raj, Thomas, 14000, Penang (MY)
(74) Representative: Epping - Hermann - Fischer

(57) **Abstract**

An arrangement for processing optoelectronic devices, comprising
- a first turret (1), and
- a second turret (2), spaced from the first turret (1) in a direction parallel to a rotational axis (6) of the first turret (1), wherein
- the first turret (1) is a component holder (101) configured to carry at least two pick up heads (5), each pick up head (5) being configured to carry an optoelectronic device,
- the first turret (1) and the second turret (2) are connected to each other in a detachable manner, and
- the second turret (2) is configured to drive a rotation of the first turret (2) about the rotational axis (6) is specified.

## Description

An arrangement for the processing of optoelectronic devices is specified.

The documents WO 2009/128698 A1 and EP 2081034 A1 describe arrangements for the processing of electronic devices. Both documents describe turrets to which a plurality of component holders is attached in a detachable manner. These component holders have to be aligned with respect to each other after a certain operating time. This alignment proves to be rather time-consuming. Further each component holder can only carry exactly one pick up head which carries the processed device during handling by the arrangement.

It is one object to specify an arrangement for processing optoelectronic devices which can be operated in a more cost-effective way. It is a further object to specify an arrangement which is mechanically more stable than the prior art arrangements.

According to at least one aspect of the arrangement for processing optoelectronic devices the arrangement comprises a first turret. The first turret is, for example, in the form of a ring-shaped plate. The first turret functions as a conveyor which can take a plurality of indexed positions. Several regularly spaced locations of processing stations can be defined around the first turret, each of which is generally occupied by a processing station for processing the optoelectronic device. Processing operations performed by these stations may include handling, electric testing, optical testing, sorting, binning, etc., of the optoelectronic devices. The processing stations placed around the turret can form a cycle of successive operations performed by the conveyed optoelectronic device.

According to at least one aspect of the arrangement the first turret is a component holder configured to carry at least two pick up heads. In other words, there are no additional component holders which are fixed to the first turret, but the first turret is formed as a component holder itself. It is possible that the arrangement comprises only one single component holder.

This component holder is able to carry at least two pick up heads, in particular a plurality of pick up heads. Each pick up head is configured to carry one of the optoelectronic devices processed by the arrangement. For example each pick up head comprises a pick up nozzle which is configured to take and hold the optoelectronic device. For example the pick up nozzle takes and holds the optoelectronic device through air-vacuum.

According to at least one aspect of the arrangement the arrangement comprises a second turret which is spaced from the first turret in a direction parallel to a rotational axis of the first turret. In other words, the first and the second turret are individual components which are not in direct contact with each other, but which are spaced from each other. For example the first and the second turret are spaced from each other in a direction parallel to the rotational axis about which the first turret rotates during operation of the arrangement.

According to at least one aspect of the arrangement the first turret and the second turret are connected to each other in a detachable manner. "Connected in a detachable manner" means that a connection between the first turret and the second turret can be solved using mechanical force without destroying the first turret, the second turret or any other component of the arrangement. After solving the connection between the first turret and the second turret, it is possible to reconnect the first turret and the second turret in a detachable manner. For example the connection between first turret and second turret can be solved for maintenance reasons.

According to at least one aspect of the arrangement the second turret is configured to drive a rotation of the first turret about the rotational axis. That means that the first turret and the second turret are connected to each other in such a way that a force can be transmitted from the second turret to the first turret. This force drives a rotation of the first turret about the rotational axis.

According to at least one aspect of the arrangement for processing optoelectronic devices the arrangement comprises a first turret and a second turret, spaced from the first turret in a direction parallel to a rotational axis of the first turret. Thereby the first turret is a component holder configured to carry at least two pick up heads, each pick up head being configured to carry an optoelectronic device, the first turret and the second turret are connected to each other in a detachable manner and the second turret is configured to drive a rotation of the first turret about the rotational axis.

The fact that the first turret can be a component holder which is able to carry at least two pick up heads allows for an arrangement where there is no need for an alignment of the component holders with respect to each other. This allows for a very cost-effective way to operate the arrangement. For example the alignment of the component holders according to the prior art arrangements can take up half a day or more.

The construction of the arrangement with two turrets, a first turret and a second turret which are connected to each other in detachable manner, allows for particularly easy maintenance of the arrangement.

According to at least one aspect of the arrangement the first turret and the second turret share the rotational axis. For example the second turret is formed as a circular or as a ring-shaped plate or similar to a circular or a ring-shaped plate. Both turrets, the first and the second turret, rotate about the same rotational axis which, for example, runs through the balance points of both turrets. By way of such an arrangement the alignment of the first turret and the second turret with respect to each other is especially easy.

According to at least one aspect of the arrangement the first turret carries at least two pick up heads. In other words, the first turret is not only configured to carry at least two pick up heads, but the first turret carries at least two, for example a plurality, of pick up heads. The pick up heads are attached to the first turret in a detachable manner and can be replaced, for example for maintenance reasons. However, the pick up heads cannot move with respect to each other due to the fact that the first turret forms a one-piece component holder. Consequently, no alignment of the pick up heads with respect to each other is necessary.

According to at least one aspect of the arrangement, the first turret is a single piece component holder. In particular it is possible that the first turret is the only component holder of the arrangement. Consequently, there is no need for alignment of component holders with respect to each other.

According to at least one aspect of the arrangement the first turret has a ring-shaped or circular base body which is formed in one piece with at least two protrusions, each protrusion extending in a radial direction of the ring or circle and configured to carry one pick up head. The rotational axis of the first turret, for example, runs through the center of the ring forming the base body. For example the first turret comprises a plurality of protrusions which are spaced from each other in constant angles around the base body. For example the first turret comprises 32 protrusions. Each protrusion is configured to take up exactly one pick up head. Consequently, the first turret forms a component holder which, for example, is able to take up two or more, e.g. 32, pick up heads.

According to at least one aspect of the arrangement the first turret and the second turret are connected to each other via detachable alignment means which are configured to prevent a rotation of the first turret and the second turret with respect to each other. In other words, the detachable alignment means keep the so-called "theta alignment" of the two turrets.

The alignment means can be removed, for example in order to rotate the first turret independently from the second turret. For example, during operation of the arrangement it is possible that a processed optoelectronic device gets stuck in the arrangement. In this case the alignment means can be detached from the first and the second turret and the first turret can be rotated by hand independently from the second turret in order to remove the stuck device. However, due to the one-piece form of the component holder there is no need for a complicated and time consuming alignment after the manual rotation of the first turret. Rather, an alignment between the first turret and the second turret can be easily achieved after the stuck device has been removed by simply reattaching the alignment means between the first turret and the second turret.

According to at least one aspect of the arrangement the alignment means comprise at least two dowel pins, each dowel pin being connected in a detachable manner to the first turret at its lower end and to the second turret at the upper end of the dowel pin. For example the dowel pins are connected to the turrets by means of interference fits. Therefore both turrets can comprise openings or recesses which are adapted to hold a respective end of a dowel pin.

According to at least one aspect of the arrangement the arrangement further comprises at least two spacers which are arranged between the first turret and the second turret, wherein the spacers keep the distance between the first turret and the second turret. For example the spacers are formed with a plastic material. The spacers can be attached to at least one of the turrets by the means of a fixing material, like a screw, bolt or glue.

Accordingly, the alignment means ensure that there is no misalignment between the first and the second turret in a way that the first turret and the second turret cannot rotate with respect to each other. The spacers ensure an alignment of the first turret and the second turret in a direction parallel to the rotational axis about which both turrets rotate. The spacers secure a minimum clearance between both turrets.

According to at least one aspect of the arrangement, the arrangement further comprises at least one servo motor which is connected to the second turret and configured to drive a rotation of the second turret. The servo motor drives the second turret which itself drives the rotation of the first turret. The force driving the rotation of the first turret can be transmitted via the detachable alignment means.

According to at least one aspect of the arrangement, the arrangement is configured to sort or bin a plurality of optoelectronic devices. For example the arrangement can be part of an optoelectronic device sorter where optoelectronic devices like light-emitting diodes are binned according to the wavelengths of the light emitted by the light-emitting diodes during operation.

The arrangement can be used as a foil handler, where the optoelectronic devices are picked up from a foil which conveys the optoelectronic devices.

In the following the here described arrangement is explained in more detail using exemplary embodiments and respective illustrations.
Figures 1A and 1B show a turret with a plurality of pick up heads according to the prior art.
Figures 2A, 2B and 2C show an exemplary embodiment of a here described arrangement in schematic illustrations.
Figures 3A and 3B show a further exemplary embodiment of a here described arrangement in schematic illustrations.

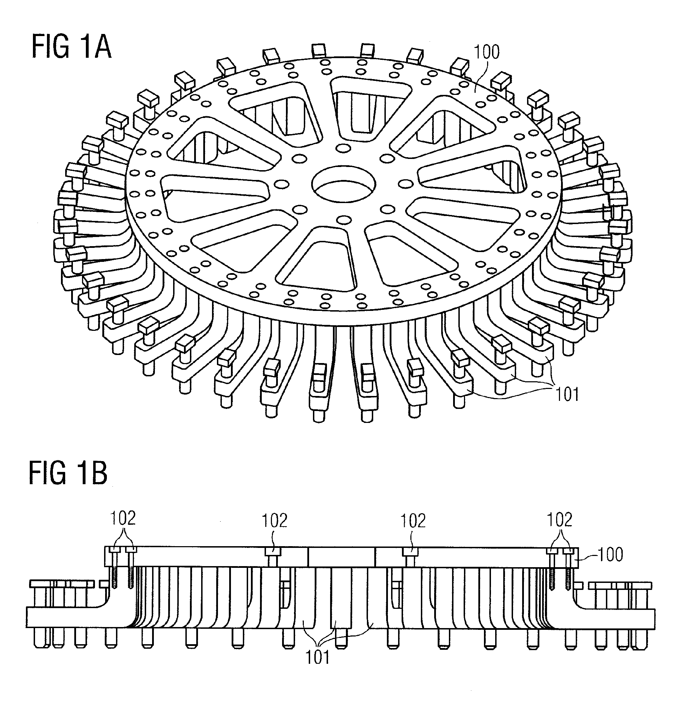

Figure 1A shows a perspective illustration of an arrangement for processing optoelectronic devices according to the prior art, Figure 1B shows a sectional view of such an arrangement.

In the exemplary embodiments and figures, similar acting constituent parts are provided with the same reference symbols. The elements illustrated in the figures and their size relationships among one another should not be regarded as true to scale. Rather, individual elements may be represented with an exaggerated size for the sake of better representability and/or for the sake of better understanding.

The arrangement according to the prior art comprises a ring-shaped turret 100. This ring-shaped turret 100 is used to drive a plurality of component holders 101 which are attached to the turret 100. For example the turret 100 is connected to a servo motor which drives the rotation of the turret 100 and thereby a rotation of the component holders 101. Each component holder can be fixed to the turret 100 by means of a screw 102.

The current arrangement according to the prior art has the problem that if the turret 100 is manually rotated by holding one of the component holders 101, the position of the component holders with respect to each other shifts if a certain amount of load is applied. The misaligned pick up heads cause scratches to parts of the optoelectronic devices, for example to lenses of the devices, during the handling by the arrangement. There is no means for detection on the arrangement to detect the misalignment component holders. An alignment of the component holders with respect to each other takes approximately up to half a day as the procedure to check and realign the component holders 101 is rather complex and the number of the component holders can be up to 32. Each component holder can carry a single pick up head which is configured to take and hold the processed device during operation.

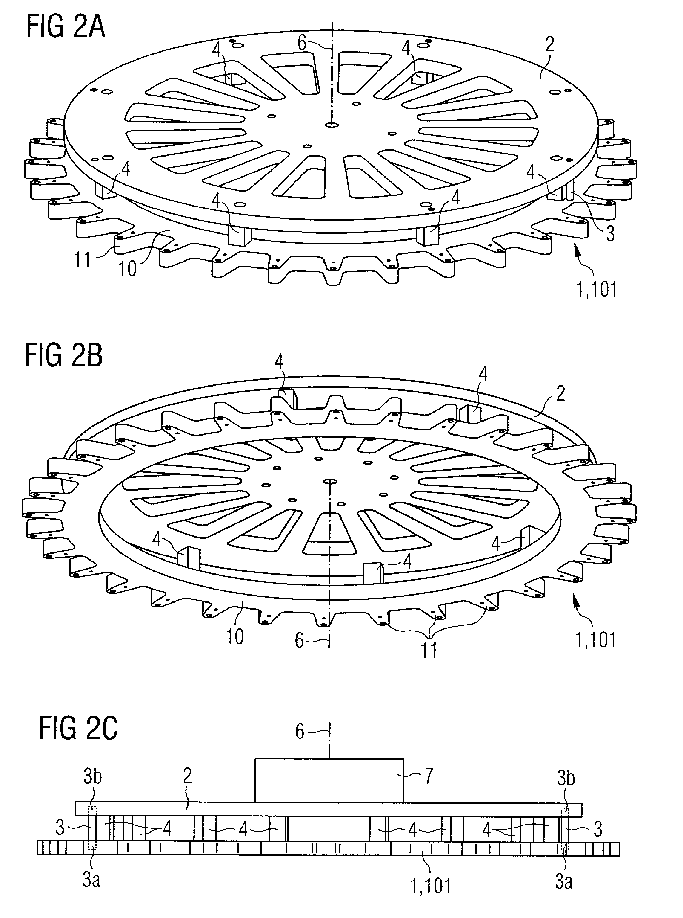

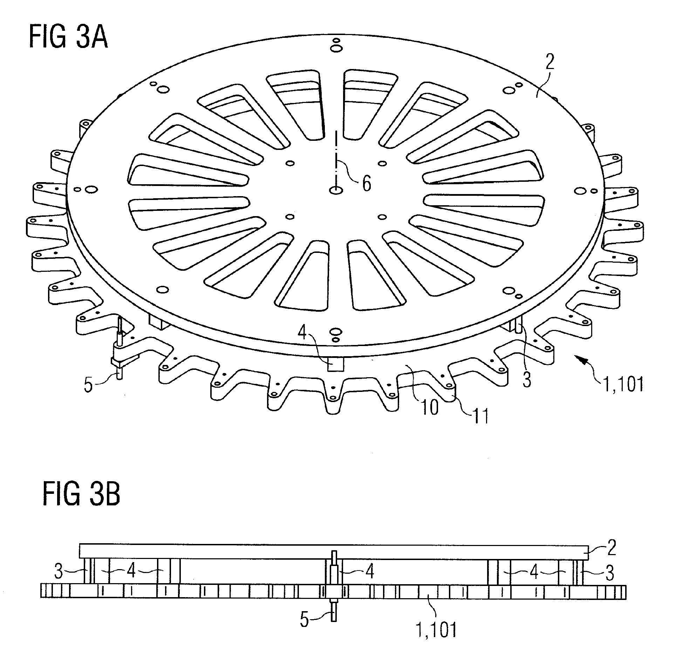

Figures 2A to 2C show schematic illustrations of a first embodiment of a here described arrangement for processing an optoelectronic device. The arrangement comprises a first turret 1 and a second turret 2. The first turret 1 is a single pieced component holder 101 which is able to hold a plurality of pick up heads 5 (see for example Figure 3A). The first turret 1 comprises a ring-shaped base body 10 with a plurality of protrusions 101 which extend in a radial direction perpendicular to the rotational axis 6 about which the turrets 1, 2 rotate during operation of the arrangement. Each protrusion is configured to hold exactly one pick up head. As the component holder 101 is formed in one piece there is no need for alignment of the protrusions with respect to each other.

The first turret 1 and the second turret 2 are spaced from each other by means of spacers, for example by eight spacers arranged in a regular manner around the rotational axis 6. These spacers provide a fixed distance between both turrets 1, 2 in a direction parallel to the rotational axis 6.

The arrangement further comprises at least two alignment means 3 which are given by dowel pins. A lower end 3a of each pin is stuck to the first turret by means of an interference fit in a detachable manner. The upper end 3b is stuck via an interference fit to the second turret 2. The alignment means 3 provide an alignment between the first turret and the second turret in a way that no relative rotation between both turrets can occur.

If a device is stuck, the alignment means 3 can be removed and the first turret 1 forming the one-piece component holder 101 can be moved independently from the second turret without the possibility of misalignment between the pick up heads 5 attached to the first turret 1.

For example a servo motor 7 attached to the second turret 2 drives the rotation of both turrets about the rotational axis 6 (see Figure 2C).

In accordance with Figures 3A and 3B a further embodiment of the arrangement is shown in schematic illustrations. In addition to the embodiment of Figures 2A to 2C, Figures 3A and 3B show a pick up head 5, for example comprising a pick up nozzle, attached to one of the protrusions 11 of the first turret 1. In principle, each protrusion 11 can carry a single pick up head. Accordingly, the first turret 1 forms a component holder 101 which can take up a plurality of pick up heads 5.

The invention is not restricted to the exemplary embodiments by the description on the basis of said exemplary embodiments. Rather, the invention encompasses any new feature and also any combination of features, which in particular comprises any combination of features in the patent claims and any combination of features in the exemplary embodiments, even if this feature or this combination itself is not explicitly specified in the patent claims or exemplary embodiments.

## Claims

1. Arrangement for processing optoelectronic devices, comprising
- a first turret (1), and
- a second turret (2), spaced from the first turret (1) in a direction parallel to a rotational axis (6) of the first turret (1), wherein
- the first turret (1) is a component holder (101) configured to carry at least two pick up heads (5), each pick up head (5) being configured to carry an optoelectronic device,
- the first turret (1) and the second turret (2) are connected to each other in a detachable manner, and
- the second turret (2) is configured to drive a rotation of the first turret (2) about the rotational axis (6).

2. The arrangement of claim 1, wherein
the first turret (1) and the second turret (2) share the rotational axis (6).

3. The arrangement of one of the preceding claims, wherein the first turret (1) carries at least two pick up heads (5).

4. The arrangement of one of the preceding claims, wherein the first turret (1) is a single piece component holder (101).

5. The arrangement of one of the preceding claims, wherein the first turret (1) has a ring-shaped or a circular base body (10) which is formed in one piece with at least two protrusions (11), each protrusion extending in a radial direction of the ring or circle and being configured to carry one pick up head (5).

6. The arrangement of one of the preceding claims, wherein the first turret (1) and the second turret (2) are connected via detachable alignment means, which are configured to prevent a rotation of the first turret (1) and the second turret (2) with respect to each other.

7. The arrangement of the preceding claim, wherein
the alignment means comprise at least two dowel pins (3), each dowel pin (3) being connected in a detachable manner to the first turret (1) at its lower end (3a) and to the second turret (2) at its upper end (3b).

8. The arrangement of one of the preceding claims,
further comprising at least two spacers (4) arranged between the first turret (1) and the second turret (2), wherein the spacers (4) keep the distance between the first turret (1) and the second turret (2).

9. The arrangement of one of the preceding claims,
further comprising at least one servo motor (7) which is connected to the second turret (2) and configured to drive a rotation of the second turret (2).

10. The arrangement of one of the preceding claims, configured to sort or bin a plurality of optoelectronic devices.
